(19) Europäisches Patentamt
European Patent Office
Office européen des brevets

(11) **EP 0 905 782 B1**

(12) **EUROPÄISCHE PATENTSCHRIFT**

(45) Veröffentlichungstag und Bekanntmachung des Hinweises auf die Patenterteilung:
**03.10.2007 Patentblatt 2007/40**

(51) Int Cl.:
***H01L 27/02*** *(2006.01)*

(21) Anmeldenummer: **98115180.6**

(22) Anmeldetag: **12.08.1998**

(54) **Integrierte Halbleiterschaltung mit Schutzstruktur zum Schutz vor elektrostatischer Entladung**

Integrated semiconductor circuit including electrostatic discharge protection means

Circuit intégré semi-conducteur comprenant des moyens de protection contre des décharges électrostatiques

(84) Benannte Vertragsstaaten:
**DE FR GB IT**

(30) Priorität: **30.09.1997 DE 19743230**

(43) Veröffentlichungstag der Anmeldung:
**31.03.1999 Patentblatt 1999/13**

(73) Patentinhaber:
• **Infineon Technologies AG**
**81669 München (DE)**
Benannte Vertragsstaaten:
**DE**
• **Qimonda AG**
**81739 München (DE)**
Benannte Vertragsstaaten:
**FR GB IT**

(72) Erfinder:
• **Gossner, Harald, Dr.**
**81735 München (DE)**
• **Stecher, Matthias, Dr.**
**9500 Villach (AT)**

(74) Vertreter: **Reinhard - Skuhra - Weise & Partner**
**Postfach 44 01 51**
**80750 München (DE)**

(56) Entgegenhaltungen:
**EP-A- 0 414 934**     **EP-A- 0 768 713**
**WO-A-95/17011**     **US-A- 4 463 369**

**Beschreibung**

Die Erfindung betrifft eine integrierte Halbleiterschaltung, die in zumindest einem Halbleiterkörper angeordnet ist, und die die Merkmale des Anspruchs 1 aufweist.

Ein ESD-Schutzelement ist aus J. Chen, X. Zhang, A. Amerasekera und T. Vrostos; Design and Layout of a High ESD Performance NPN Structure for Submicron BiC-MOS/Bipolar Circuits, Proc. Of the IEEE International Reliability Physics Symposium (1996), S. 227 bekannt.

Ferner ist ein ESD-Schutzelement aus der EP 0 768 713 A2 bekannt. Weitere ESD-Schutzschaltungen sind aus der EP 0 414 934 A1 und der US 4,463,369 bekannt.

In einem Chip integrierte Halbleiterschaltungen enthalten Schutzschaltungen zum Schutz der Ein- oder Ausgänge (I/O-Ports) gegen elektrostatische Überspannungen und dadurch verursachte elektrostatische Entladungen (Electrostatic Discharge (ESD)). Diese sogenannten ESD-Schutzelemente sind zwischen dem Eingangspad einer integrierten Halbleiterschaltung und dem zu schützenden Eingangs- oder Ausgangsanschluß angeschlossen und sorgen somit dafür, daß bei Einkopplung einer parasitären Überspannung das ESD-Schutzelement durchschaltet und der parasitäre Überspannungsimpuls somit an eine der Versorgüngsspannungsleiterbahnen abgeleitet wird. Derartige Überspannungsimpulse können im Extremfall zur Zerstörung des Bauteiles führen.

Unter Operationsbedingungen, wie sie z. B. in der Produktspezifikation beschrieben sind, dürfen die ESD-Schutzelemente die Funktion der zu schützenden integrierten Halbleiterschaltungen jedoch nicht beeinträchtigen. Das bedeutet, daß die Durchschaltspannung der ESD-Schutzelemente außerhalb des Signalspannungsbereiches der geschützten Anschlußpads liegen muß. Um eine gute Schutzwirkung entfalten zu können, sollte das ESD-Schutzelement vor dem kritischsten Schaltungspfad durchbrechen. Dies erfordert in der Regel eine exakte Einstellung der Durchschaltspannung der jeweiligen ESD-Schutzelemente mit der wesentlichen Randbedingung, daß die Prozeßführung, die hinsichtlich der Eigenschaften der Bauelemente der zu schützenden integrierten Halbleiterschaltung optimiert wurde, durch das Einfügen der ESD-Schutzelemente nicht verändert wird.

Eine weitere wesentliche Randbedingung ergibt sich aus der räumlichen Anordnung der Anschlußpads in unmittelbarer Nähe der zu schützenden integrierten Halbleiterschaltung. Insbesondere werden die Anschlußpads wegen des relativ hohen zu treibenden Strom in der Nähe der Ausgangstreiber angeordnet. Die ESD-Schutzstruktur wird daher häufig an diejenige Versorgungsleitung angeschlossen, aus der der Ausgangstreiber versorgt wird.

Für Anschlüsse, die sehr schnellen Spannungsflanken ausgesetzt sein können, ohne daß die äußere Beschaltung eine hinreichende Strombegrenzung gewährt, ist beim Einsatz von ESD-Schutzelementen, die im Durchbruch ein sogenanntes Snap-Back-Verhalten aufweisen, besonders darauf zu achten, daß die Haltespannung über der spezifizierten Signalspannung liegt, um so ein transientes Durchschalten (Latch-Up-Effekt) der ESD-Schutzelemente zu vermeiden. Dieser Latch-Up-Effekt der ESD-Schutzelemente führt häufig zu deren Zerstörung und somit auch zur Zerstörung der nachgeschalteten integrierten Halbleiterschaltung.

Trotz der hohen ESD-Festigkeit und der guten Schutzwirkung können aus diesen Gründen Schutztransistoren, insbesondere npn-Bipolartransistoren, oder Thyristoren mit einer Haltespannung im Signalspannungsbereich nicht als ESD-Schutzelemente eingesetzt werden. Dies trifft insbesondere für in Smart-Power-Technologie hergestellte Halbleiterschaltungen zu. Man ist hier auf Durchbruchdioden oder Transistoren mit einer geringen Verstärkung beschränkt, die eine im Vergleich zu den oben beschriebenen Bauelementen geringe ESD-Festigkeit besitzen.

Die Haltespannung von npn-Bipolartransistoren, insbesondere von aktiv angesteuerten npn-Bipolartransistoren, wird durch die Beziehung

$$U_H = U_{CB} * \beta^{-1/4}$$

beschrieben. Dabei ist $\beta$ die Kollektor-Basis-Stromverstärkung und $U_{CB}$ die Kollektor-Basis-Durchbruchspannung.

Zur Erhöhung der Haltespannung der Bipolartransistoren muß nach obiger Gleichung entweder die Kollektor-Basis-Durchbruchspannung erhöht werden oder die Stromverstärkung verringert werden. Eine Verringerung der Stromverstärkung ist jedoch nicht vorteilhaft, da sich damit auch die Schutzwirkung verschlechtert würde.

Somit muß zur Erhöhung der Haltespannung des Schutzelements eine Vergrößerung der Kollektor-Basis-Durchbruchspannung vorgenommen werden. Es dürfen jedoch dabei die Durchbruchspannungen der übrigen Bauelemente der integrierten Halbleiterschaltung nicht verändert werden. Aus den oben beschriebenen Randbedingungen wird somit eine Vergrößerung der Epitaxieschichtdicke bzw. eine Verringerung der Dotierung in der Epitaxieschicht ausgeschlossen.

Bezüglich weiterer Einzelheiten, Merkmale, deren Vorteile und Wirkungsweise der ESD-Schutzschaltungen wird ausdrücklich auf die Europäische Patentanmeldung EP 0 623 958 A1 sowie auf das eingangs genannte Dokument von J. Chen et al. verwiesen.

Ausgehend von diesem Stand der Technik liegt der Erfindung daher die Aufgabe zugrunde, eine ESD-Schutzstruktur der eingangs genannten Art bereitzustellen, deren Haltespannung ohne Verschlechterung der ESD-Festigkeit und der Schutzwirkung und bei den vorgegebenen Randbedingungen erhöht wird.

Erfindungsgemäß wird diese Aufgabe durch ein ESD-Schutzelement gemäß Anspruch 1 gelöst.

Insbesondere wird durch eine laterale Strukturierung des als vergrabene Schicht ausgebildeten Kollektors des Schutztransistors der Abstand zwischen Basis und Kollektor vergrößert. Auf diese Weise vergrößert sich die Verarmungszone des Transistors in der Epitaxieschicht und es verringern sich die elektrischen Felder bei gleichen Potentialdifferenzen. Somit steigt die Durchbruchspannung $U_{CB}$ an.

Besonders vorteilhaft ist die Erfindung, wenn der Schutztransistor durch eine in Sperrichtung geschaltete Diode angesteuert wird. Insbesondere bei Beschaltung der Basis mit einer Diode, deren Durchbruch im Bereich der Haltespannung des Schutztransistors liegt, läßt sich somit ein fast ideales ESD-Schutzelement entwickeln, das eine einstellbare Spannungsbegrenzung bis in den Amperebereich zwischen der Signalspannungsobergrenze und der Durchbruchspannung kritischer Spannungspfade besitzt.

Besonders vorteilhaft ist es, wenn zwischen Emitter- und Basisanschlüssen des Schutztransistors ein integrierter Widerstand vorgesehen ist. Der integrierte Widerstand läßt sich die Ansteuerempfindlichkeit der Basis des Schutztransistors einstellen. Typischerweise ist der integrierte Widerstand bei geeigneter Verschaltung der Emitter- und Basisanschlüsse durch den Leitwert der Basiszone festgelegt.

Die vergrabene Schicht ist dabei über eine Anschlußzone, die aus Gründen einer guten Leitfähigkeit möglichst hoch dotiert ist, mit dem Anschlußpad verbunden. Die Anschlußzone definiert dabei einen Teilbereich, in dem der Schutztransistor angeordnet sind. Typischerweise ist der Teilbereich in einer Epitaxieschicht angeordnet. Besonders vorteilhaft ist es, wenn die Anschlußzone als geschlossener Ring um den Teilbereich angeordnet ist.

Die Anschlußzonen sind dabei äquidistant durch einen zweiten Abstand von den Basiszonen beabstandet. Der zweite Abstand ist typischerweise ausreichend groß zu wählen, so daß der parasitäre Bipolartransistor im Randbereich der Teilzone nicht durchschaltet. In der Smart-Powertechnologie ist der zweite Abstand typischerweise mit größer als 20 $\mu$m einzustellen. Bei Hochfrequenzanwendung ist er etwa 2-3 $\mu$m.

Typischerweise weist die Emitterzone eine sehr viel höhere Dotierungskonzentration auf, als die Basiszonen bzw. die Epitaxieschicht. Die Dotierungskonzentration in der Epitaxieschicht ist oftmals von der Prozeßführung zur Herstellung der integrierten Schaltung festgelegt.

Die vergrabene Schicht und die Anschlußzonen sind um den Anforderungen eines sehr hohen Leitwertes Genüge zu leisten, sehr hoch dotiert. Typischerweise weisen diese Zonen eine Dotierungskonzentration von mehr als $1*10^{19}$ cm$^{-3}$ auf.

Es ist auch denkbar, eine Anodenzone zwischen Kollektoranschluß und Anschlußpad anzuordnen ist. In diesem Fall ist das ESD-Schutzelement als IGBT oder als Thyristor ausgebildet.

Besonders vorteilhaft ist die Erfindung bei Verwendung in einem Halbleiterspeicher bzw. einem Logikbauteil. Eine weitere vorteilhafte Anwendung findet die Erfindung in der Verwendung in einem Microcontroller.

Typischerweise ist die Erfindung in bipolar realisierten Schaltungen integriert. Besonders vorteilhaft ist es jedoch, wenn die integrierte Halbleiterschaltung sowie das ESD-Schutzelement in CMOS-Technologie hergestellt ist.

Vorteilhafte Ausgestaltungen und Weiterbildungen sind Kennzeichen der weiteren Unteransprüche.

Nachfolgend wird die Erfindung anhand der in den Figuren der Zeichnung angegebenen Ausführungsbeispiele näher erläutert. Es zeigt dabei:

Figur 1  die Schaltungsanordnung einer bekannten integrierten Halbleiterschaltung mit vorgeschaltetem ESD-Schutzelement;

Figur 2  eine schematische Darstellung der Realisierung einer erfindungsgemäßen ESD-Schutzstruktur in einem Halbleitersystem;

Figur 3  eine schematische Darstellung der Realisierung einer bevorzugten Ausführung der erfindungsgemäßen ESD-Schutzstruktur in einem Halbleitersystem gemäß Figur 1.

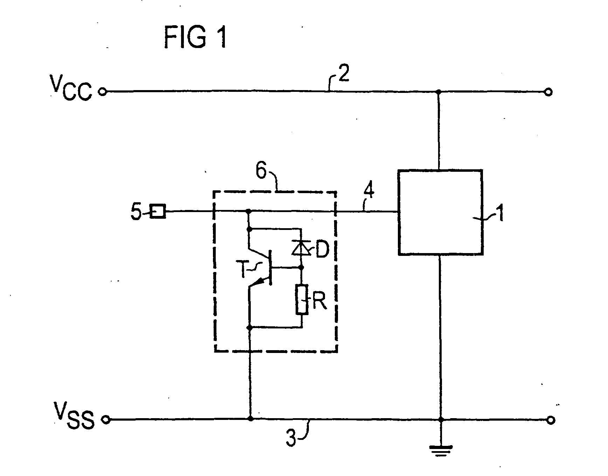

Figur 1 zeigt eine Schaltungsanordnung einer bekannten integrierten Halbleiterschaltung mit vorgeschaltetem ESD-Schutzelement.

In Figur 1 ist mit 1 die integrierte Halbleiterschaltung bezeichnet. Die integrierte Halbleiterschaltung 1 ist an eine erste Potentialschiene 2 mit einem ersten Versorgungspotential VCC sowie eine zweite Potentialschiene 3 mit einem zweiten Versorgungspotential VSS angeschlossen. Das erste Versorgungspotential VCC kann beispielsweise die Versorgungsspannung sein. Das zweite Versorgungspotential VSS kann wie im vorliegenden Beispiel die Bezugsmasse sein.

Über eine Verbindungsleitung 4 ist die integrierte Halbleiterschaltung 1 mit einem Anschlußpad 5 verbunden. Das Anschlußpad 5 kann sowohl ein Eingangsanschluß zur Einkopplung von Eingangssignalen in die integrierte Halbleiterschaltung 1 sein, als auch ein Ausgangsanschluß zum Auskoppeln von Ausgangssignalen aus der integrierten Halbleiterschaltung 1. Derartige Anschlüsse werden auch als I/O-Ports bezeichnet.

Zwischen das Anschlußpad 5 und der integrierten Halbleiterschaltung 1 ist ein ESD-Schutzelement 6 geschaltet. Außerdem ist das ESD-Schutzelement 6 mit der zweiten Potentialschiene 3 verbunden.

Im vorliegenden Beispiel besteht das ESD-Schutzelement 6 aus einem npn-Schutztransistor T, dessen Laststrecke zwischen der Verbindungsleitung 4 und der Potentialschiene 3 geschaltet ist. Es wäre auch denkbar, als Schutztransistor T einen pnp-Transistor zu verwenden. Dies hängt jedoch von der zugrunde liegenden Technologie zur Herstellung der integrierten Halbleiterschaltung 1 ab. Es wäre natürlich auch denkbar, den Schutztransistor T alternativ als MOSFET, als Sperrschicht-FET, als Thyristor, als IGBT oder als ein gängiges steuerbares Bauelement, das geeignet verschaltet ist, zu realisieren.

Zwischen der Basis-Kollektor-Strecke des Schutztransistors T ist eine Diode D vorgesehen. Zwischen der Basis-Emitter-Strecke des Schutztransistors T ist ein Widerstand R vorgesehen. Im vorliegenden Beispiel wird der Basisanschluß des Schutztransistors T durch die in Sperrichtung geschaltete Diode D aktiv angesteuert. Die Ansteuerspannung des Schutztransistors T kann über eine geeignete Dimensionierung des Widerstandes R eingestellt werden. Es ist jedoch auch denkbar, daß der Schutztransistor T nicht aktiv angesteuert wird. In diesem Fall kann auf die Diode D verzichtet werden.

Im vorliegenden Beispiel ist das ESD-Schutzelement 6 zwischen der Anschlußleitung 4 und der zweiten Potentialschiene 3 geschaltet. Es wäre selbstverständlich auch denkbar, das ESD-Schutzelement 6 zwischen der Verbindungsleitung 4 und der ersten Potentialschiene 2 bzw. zwischen der Verbindungsleitung 4 und beiden Potentialschienen 2, 3 anzuordnen.

Das ESD-Schutzelement 6 soll die integrierte Halbleiterschaltung 1 vor parasitären, über das Anschlußpad 5 eingekoppelten Störsignalen schützen. Diese parasitären Störsignale werden über das ESD-Schutzelement 6 an eine der Potentialschienen 2, 3 abgeleitet und gelangen somit nicht in die integrierte Halbleiterschaltung 1.

Derartige Störsignale können beispielsweise beim Transport bzw. beim Handling des Halbleiterchips entstehen. Dadurch kann der Halbleiterchip elektrostatisch aufgeladen werden.

Wird die elektrostatische Ladung in die integrierte Halbleiterschaltung 1 eingekoppelt, kann dies im Extremfall zur Zerstörung der integrierten Halbleiterschaltung 1 führen.

Zur Simulierung einer Störsignaleinkopplung wird typischerweise das sogenannte Human-Body-Modell (HBM) angewendet. Das Ersatzschaltbild des Human-Body-Modells sieht einen Tiefpaß, bestehend aus einer Kapazität von 100 pF und einem Widerstand von 1,5 KΩ, vor. Das Human-Body-Modell simuliert ein durch einen Menschen eingekoppeltes Störsignal. Es ist auch denkbar, andere Modelle wie beispielsweise das sogenannte Charged-Device-Modell (CDM) zu verwenden.

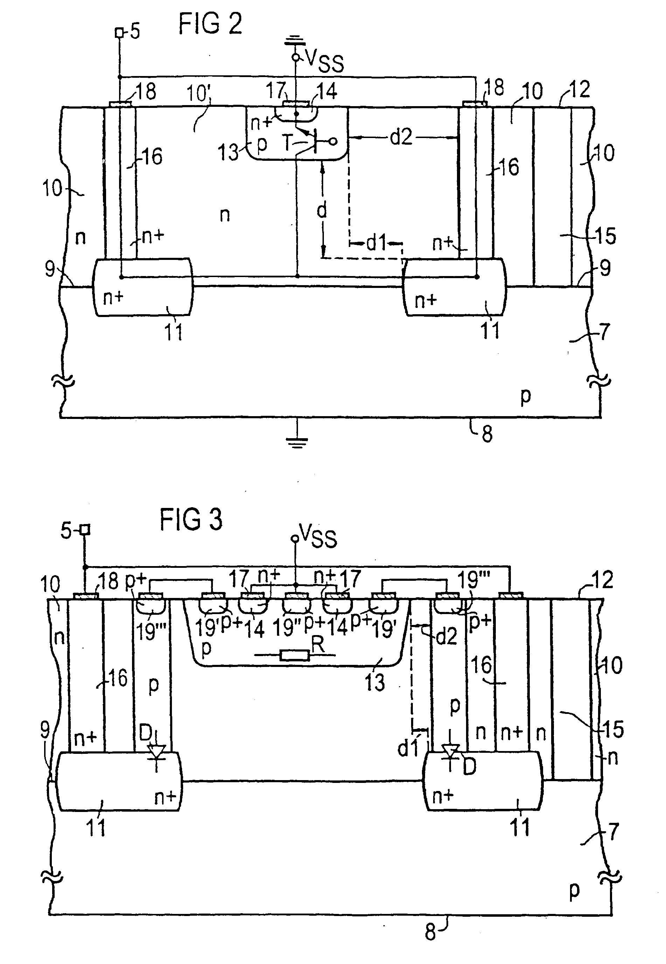

Figur 2 zeigt eine eine schematische Darstellung der Realisierung einer erfindungsgemäßen ESD-Schutzstruktur in einem Halbleitersystem. Gleiche Elemente sind entsprechend Figur 1 mit gleichen Bezugszeichen versehen.

In Figur 2 ist mit 7 ein Halbleiterkörper bezeichnet. Der Halbleiterkörper 7 besteht typischerweise aus Siliziumsubstrat. Der Halbleiterkörper 7 weist eine Scheibenrückseite 8 und eine Substratoberfläche 9 auf. Im vorliegenden Beispiel ist das Siliziumsubstrat des Halbleiterkörpers 7 p-dotiert und liegt auf der Scheibenrückseite 8 auf dem Potential der Bezugsmasse. Es ist selbstverständlich auch denkbar, daß das Halbleitersubstrat n-dotiert ist.

Auf der Substratoberfläche 9 des Halbleiterkörpers 7 ist eine schwach n-dotierte Epitaxieschicht 10 aufgebracht. Für die Funktion der ESD-Schutzstruktur wäre es auch denkbar mehrere Epitaxieschichten 10 übereinander anzuordnen oder auf die Epitaxieschicht 10 ganz zu verzichten. Die Dotierungskonzentration in der Epitaxieschicht 10 ist von der Prozeßführung zur Herstellung der integrierten Halbleiterschaltung 1 festgelegt. Typischerweise weist die Epitaxieschicht eine Dotierungskonzentration von $1*10^{15}$ cm$^{-3}$ bis $1*10^{18}$ cm$^{-3}$ auf. Die Dicke der Epitaxieschicht 10 variiert dabei je nach angewendeter Technologie zwischen 1-10 μm.

Zusätzlich ist, wie in Figur 2 gezeigt, eine vergrabene Schicht 11 vorgesehen. Eine derartige vergrabene Schicht 11 wird auch als Buried-Layer bezeichnet. Im vorliegenden Beispiel ist die vergrabene Schicht 11 n+-dotiert. Die vergrabene Schicht 11 kann beispielsweise durch Einbringen eines Depots auf der Substratoberfläche 9 vor Aufwachsen der Epitaxieschicht 10 und anschließender Diffusion bei geeigneter Temperatur erzeugt werden.

Es ist jedoch auch vorteilhaft, wenn die vergrabene Schicht 11 durch Ionenimplantation in den Halbleiterkörper 7 nach Aufwachsen bzw. während dem Aufwachsen der Epitaxieschicht 10 erzeugt wird. Um das gewünschte vertikale Profil zu erzielen, ist hierbei häufig eine Mehrfachimplantation bei geeigneten Energien und Dotierungsdosen erforderlich. Hieran sollte ein Temperaturschritt zur homogenen Verteilung der Dotieratome in der vergrabenen Schicht 11 angeschlossen werden.

Die Dotierungskonzentration in der vergrabenen Schicht 11 ist oftmals durch die Prozeßführung bei der Herstellung der integrierten Schaltung 1 vorgegeben. Um eine möglichst gute Leitfähigkeit zu gewährleisten, sollte die vergrabene Schicht 11 möglichst niederohmig ausgebildet ist. Aufgrund dessen weist die vergrabene Schicht 11 typischerweise eine Dotierungskonzentration von etwa $10^{19}$ cm$^{-3}$ auf.

Die vergrabene Schicht 11 ist über Anschlußzonen 16 mit der Scheibenvorderseite 12 des Halbleiterkörpers 1 verbunden. Die Anschlußzone 16 ist vom selben Leitungstyp wie die vergrabene Schicht 11 und weist eine möglichst hohe Dotierungskonzentration von $1*10^{20}$ cm$^{-3}$ auf. Die Anschlußzone 16 erstreckt sich im vorliegenden Beispiel als tiefe Implantations- oder Diffusionszone von der Scheibenoberfläche 12 in den Halbleiterkörper 7 hinein und ist an die vergrabene Schicht 11 angeschlossen. Die Anschlußzonen 16 sind hier als Graben (engl.: Trench) ausgebildet und lassen sich in bekannter Trench-Technologie erzeugen.

In der projizierten Draufsicht (nicht dargestellt) beschreiben die Anschlußzonen 16 sowie die vergrabene Schicht 11 eine ringförmige Struktur. Die ringförmige Struktur muß jedoch nicht notwendigerweise geschlossen sein. Die ringförmige Struktur der Anschlußzone 16 kann kreisförmig, reckeckig oder vieleckig ausgebildet sein. Alternativ wäre auch eine streifenförmige Struktur denkbar.

Die vergrabene Schicht 11 einerseits und andererseits die Anschlußzonen 16 umfassen einen sogenannten Teilbereich 10' der Epitaxieschicht 10.

Im Teilbereich 10' ist an der Scheibenoberfläche 12 eine Basiszone 13 angeordnet. Die Basiszone 13 ist im vorliegenden Ausführungsbeispiel p-dotiert und wannenförmig ausgebildet. Zusätzlich ist innerhalb der Basiszone 13 an der Scheibenoberfläche 12 eine wannenförmige Emitterzone 14 vom entgegengesetzten Leitungstyp angeordnet.

Die Emitterzone 14 weist typischerweise eine Dotierungskonzentration von $5*10^{19}$ cm$^{-3}$ auf. Die Emitterzonenwanne ragt dabei etwa 1$\mu$m in den Halbleiterkörper 7 hinein. Die Basiszone 13 weist eine typische Dotierungskonzentration von $10^{16}$ - $10^{17}$cm$^{-3}$ auf, wobei deren Wanne eine Tiefe von etwa 2,5 $\mu$m aufweist.

In Figur 2 ist schematisch das Ersatzschaltbild der ESD-Schutzstruktur in dem Querschnitt dargestellt. Dabei bilden die Emitterzone 14, die Basiszone 13 und die vergrabene Schicht 11 jeweils den Emitter, die Basis und den Kollektor des Schutztransistors T. Der Schutztransistor T in Figur 2 ist nicht aktiv angesteuert. In diesem Fall ist das Schutzelement 6 als Schutztransistor T in Diodenschaltung realisiert.

Bei rein vertikalen ESD-Schutzelementen ergibt sich die Durchschaltspannung des Schutztransistors T typischerweise aus dem Abstand d der Basiszone zu der unmittelbar darunter angeordneten Kollektorzone bzw. der vergrabene Schicht 11. Durch die erfindungsgemäße sogenannte quasi-vertikale ESD-Schutzstruktur wird durch laterale Versetzung der Kollektorzone relativ zu der Basiszone dieser Abstand d vergrößert. Dadurch vergrößert sich die Durchschaltspannung der betreffenden ESD-Schutzelemente entsprechend.

Erfindungswesentlich bei der vorliegenden ESD-Struktur ist somit, daß die wannenförmige Basiszone 13 und die Ringstruktur der vergrabenen Schicht 11 derart angeordnet sind, daß die Außenkante der Wanne der Basiszone 13 lateral versetzt zu der Innenkante der vergrabenen Schicht 11 angeordnet sind. Diese laterale Versetzung ist gekennzeichnet durch einen ersten Abstand d1.

Die Basiszone 13 sind in dem Teilbereich 10' derart angeordnet, daß sie von der Anschlußzone 16 durch einen zweiten Abstand d2 beabstandet ist. Der zweite Abstand d2 ist dabei so groß zu wählen, daß die laterale, parasitäre pn-Diode im Randbereich des Teilbereichs 10' unterdrückt wird. Typischerweise ist dieser Abstand größer als 20$\mu$m.

Die Basiszone 13 und die Emitterzone 14 sind im vorliegenden Beispiel wannenförmig ausgebildet. Es wären jedoch auch V-förmige, U-förmige, trenchförmige, oder ähnliche Strukturen denkbar. Diese Zonen 13, 14 werden vorteilhafterweise durch Diffusion oder Ionenimplantation in den Halbleiterkörper 7 eingebracht. Es wäre jedoch auch eine alternative Herstellungsmöglichkeit, wie zum Beispiel eine Abscheidung oder ähnliches, denkbar.

Die Basiszone 13 und die Anschlußzone 16 sind über übliche Kontaktierungen 17, 18 an der Scheibenoberfläche 12 kontaktiert. Dabei sind jeweils die ersten Kontaktelektroden 17 der Emitterzonen 14 mit der zweiten Potentialschiene 3 und damit mit der Bezugsmasse verbunden. Die zweiten Kontaktelektroden 18 der Anschlußzonen 16 sind mit dem Anschlußpad 5 verbunden.

Zusätzlich ist in Figur 2 eine Pufferzone 15 vorgesehen, die sich von der Scheibenvorderseite 12 durch die gesamte Epitaxieschicht 10 bis in den Halbleiterkörper 7 hinein erstreckt. Im vorliegenden Beispiel besteht die Pufferzone 15 aus Siliciumdioxid. Die Pufferzone 15 kann jedoch auch durch jedes andere gängige Puffermaterial, beispielsweise hochdotiertes Polysilicium, Siliciumnitrit oder ähnlichem, gebildet werden. Die Pufferzone 15 hat üblicherweise die Funktion der Schirmung bzw. der Trennung der ESD-Schutzstrukturen gegenüber der integrierten Halbleiterschaltung 2 bzw. dem Halbleiterchip.

Besonders vorteilhaft ist es, wenn die Pufferzone 15 aus p+-dotiertem Polysilicium besteht. In diesem Fall kann die in Flußrichtung gepolte pn-Diode zwischen vergrabener Schicht 11 und p-dotiertem Substrat 7 genutzt werden, um beispielsweise negative Pulse abzuführen. Diese negativen Pulse können dann über die p+-dotierte Pufferzone 15 abgeleitet werden.

Typischerweise ist die laterale Querschnittsfläche, die von der vergrabenen Schicht 11 eingeschlossen ist größer als die von der Anschlußzone 16 eingeschlossenen entsprechenden Querschnittsfläche.

Nachfolgend wird die Funktionsweise der erfindungsgemäßen ESD-Schutzstruktur näher erläutert.

Wird über das Anschlußpad 5 ein Störsignal eingekoppelt und überschreitet dieses Störsignal die Schaltschwelle des Schutztransistors T, dann bricht die Raumladungszone am pn-Übergang des in Diodenschaltung geschalteten Schutztransistors T zusammen. Der Schutztransistor T schalten durch. Somit ergibt sich ein Strompfad vom Anschlußpad 5 über die Anschlußzonen 16, die vergrabene Schicht 11, der Basiszone 13, zur Emitterzone 14 und somit zur zweiten Potentialschiene 3. Das Störsignal wird somit auf die zweite Potentialschiene 3 abgeleitet und gelangt damit nicht in die integrierte Halbleiterschaltung 1.

Es wäre auch vorteilhaft, wenn zwischen vergrabener Schicht 11 und Anschlußpad 5 eine Anodenzone angeordnen ist. In diesem Fall ist das ESD-Schutzelement 6 als IGBT oder als Thyristor ausgebildet.

Durch geeignete Wahl der Basisweite des Schutztransistors läßt sich zusätzlich die Durchschaltspannung des aktiven Schutzelements einstellen.

Besonders vorteilhaft ist die Erfindung bei Verwendung des ESD-Schutzelements 6 in einem Mikrokontroller, in einem Halbleiterspeicher oder in einem Logikbauteil.

Die integrierte Halbleiterschaltung sowie das dazugehörige ESD-Schutzelement sind vorzugsweise bipolar oder in Smart-Power-Technologie realisiert. Besonders vorteilhaft ist es jedoch, wenn die integrierte Halbleiterschaltung 1 sowie die ESD-Schutzschaltung in CMOS-Technologie hergestellt ist.

Figur 3 zeigt eine eine schematische Darstellung der Realisierung einer bevorzugten erfindungsgemäßen ESD-Schutzstruktur in einem Halbleitersystem. Gleiche Elemente sind entsprechend Figur 1 mit gleichen Bezugszeichen versehen.

Figur 3 zeigt eine bevorzugte Weiterbildung der in Figur 2 gezeigten Struktur. In der Wanne der Basiszone 13 sind hier hochdotierte Kontaktgebiete 19', 19" vom selben Leitungstyp angeordnet. Außerdem sind in der Wanne der Basiszone 13 eine Vielzahl von Emitterzonen 14 vorgesehen.

Zusätzlich sind im Teilbereich 10' zweite Anschlußgebiete 20 vorgesehen. Die zweiten Anschlußgebiete 20 erstrecken sich äquivalent wie die Anschlußgebiete 16 von der Scheibenvorderseite 12 in den Halbleiterkörper 7 hinein und sind an die vergrabene Schicht 11 angeschlossen. Die zweiten Anschlußgebiete 20 befinden sich im vorliegenden Beispiel innerhalb des von dem Anschlußgebiet 16 eingeschlossenen Teilbereich 10'. Die zweiten Anschlußgebiete 20 sind von den Anschlußgebieten 16 beabstandet und weisen eine sehr hohe Dotierungskonzentration vom entgegengesetzten Leitungstyp auf. Im vorliegenden Fall weisen die zweiten Anschlußgebiete 20 eine p+-Dotierung mit einer Dotierungskonzentration von typischerweise $1 * 10^{20}$ cm$^{-3}$ auf.

Die zweiten Anschlußgebiete 20 weisen an der Scheibenoberfläche 12 Kontaktgebiete 19''' auf. Diese Kontaktgebiete 19''' sind über Verbindungsleitungen 21 mit entsprechenden Kontaktgebieten 19' in der Basiszone 13 verbunden. Die übrigen Kontaktgebiete 19" in der Basiszone 13 sind über Verbindungsleitungen mit den Emitterzonen 14 und somit mit dem zweiten Versorgungspotential der zweiten Potentialschiene 3 verbunden.

Die Kontaktgebiete 19', 19", 19''' weisen eine typische Dotierungskonzentration von $10^{20}$ cm$^{-3}$ auf. Deren Dotierungsprofil ragt etwa 0,5 $\mu$m bis 1 $\mu$m in den Halbleiterkörper 7 hinein.

Für die in Figur 3 gezeigte Struktur gilt das in Figur 1 gezeigte Ersatzschaltbild des ESD-Schutzelements 6 mit einem Schutztransistor T sowie einer Diode D und einem Widerstand R zu dessen Basisansteuerung. Der Übersichtlichkeit halber ist in Figur 3 dieses Ersatzschaltbild nicht eingezeichnet. Lediglich die Lage des integrierten Widerstandes R und der integrierten Diode D ist in Figur 3 angedeutet.

Der integrierter Widerstand R resultiert bei der gegenbenen Verschaltung aus der Dotierungskonzentration in der Basiszone 13 zwischen benachbarten Kontaktgebieten 19', 19". Des weiteren ist in Figur 3 jeweils zwischen den zweiten Anschlußgebieten 20 und der vergrabenen Schicht 11 eine integrierte Diode D angedeutet. Die Dioden D und der Widerstand R steuern somit die Basis des Schutztransistors T an.

Nachfolgend wird die Funktionsweise der in Figur 3 gezeigten Anordnung näher erläutert.

Wird über das Anschlußpad 5 ein Störsignal z.B. ein Stromimpuls eingekoppelt und überschreitet dieser Stromimpuls die Durchschaltschwelle der Dioden D, dann bricht die Raumladungszone am pn-Übergang der Dioden D zusammen und die Basis des Schutztransistors T wird angesteuert. Bei ausreichend hohem Basisstrom schaltet der Schutztransistor T durch. Somit ergibt sich ein Strompfad vom Anschlußpad 5 über die Anschlußzone 16, die vergrabene Schicht 11, über die Teilzone 10' und die Basiszone 13 zu den Emitterzonen 14 und somit zur zweiten Potentialschiene 3. Derartige Störimpulse gelangen somit nicht in die integrierte Halbleiterschaltung 1, sondern werden über eine der Potentialschienen 2, 3 abgeleitet.

Im Gegensatz zu der in Figur 2 gezeigten ESD-Struktur erfolgt in Figur 3 eine aktive Basisansteuerung über die integrierten Dioden D sowie über den Widerstand R. Die Durchschaltschwelle der Dioden D läßt sich über die Dotierungskonzentration in den zweiten Anschlußgebieten 20 einstellen. Somit läßt sich durch eine geeignete Dotierungskonzentration in den zweiten Anschlußzonen 20 sowie über die Dotierungskonzentration der Basiszone 13 die Ansteuerempfindlichkeit des Schutztransistors T1 einstellen.

Bezugszeichenliste

| | |
|---|---|
| 1 = | integrierte Halbleiterschaltung |
| 2 = | erste Potentialschiene |
| 3 = | zweite Potentialschiene |
| 4 = | Verbindungsleitung |
| 5 = | Anschlußpad |
| 6 = | (ESD-)Schutzelement |
| 7 = | Halbleiterkörper |
| 8 = | Scheibenrückseite |
| 9 = | Substratoberfläche |
| 10 = | Epitaxieschicht |
| 10' = | Teilbereich in der Epitaxieschicht |
| 11 = | vergrabene Schicht |
| 12 = | Scheibenvorderseite |
| 13 = | Basiszonen |
| 14 = | Emitterzonen |
| 15 = | Pufferzone |
| 16 = | Anschlußzonen |
| 17 = | erste Kontaktelektroden |

18 =      zweite Kontaktelektroden

19',19'',

19''' =      Kontaktgebiete

20 =      zweite Anschlußzonen

d =      Abstand von Basiszone und Kollektorzone bei einem rein vertikalen ESD-Schutzelement

d1 =      laterale Versetzung von Basiszone und Kollektorzone bei einem quasi-vertikalen ESD-Schutzelement

d2 =      Abstand zwischen Basiszone und Anschlußzone

D =      integrierte Diode

R =      integrierter Widerstand

T =      (ESD-)Schutztransistor

VCC =      erstes Versorgungspotential

VSS =      zweites Versorgungspotential

**Patentansprüche**

1. Integrierte Halbleiterschaltung (1), die in zumindest einem Halbleiterkörper (7) angeordnet ist,

    a) mit mindestens einem Anschlußpad (5), das über eine elektrisch leitende Verbindungsleitung (4) mit der integrierten Halbleiterschaltung (1) verbunden ist,
    b) mit mindestens einer ersten Potentialschiene (2), die im Betrieb ein erstes Versorgungspotential (VCC) der integrierten Halbleiterschaltung (1) führt,
    c) mit mindestens einer zweiten Potentialschiene (3), die im Betrieb ein zweites Versorgungspotential (VSS) der integrierten Halbleiterschaltung (1) führt,
    d) mit mindestens einem Schutzelement (6) zum Schutz der integrierten Halbleiterschaltung (1) vor elektrostatischer Entladung, wobei das Schutzelement (6) zwischen das Anschlußpad (5) und der integrierten Halbleiterschaltung (1) angeordnet ist und an mindestens eine der Potentialschienen (2, 3) angeschlossen ist,
    e) wobei das Schutzelement (6) mindestens einen integrierten vertikalen Schutztransistor (T) aufweist, dessen Laststrecke zwischen der Verbindungsleitung (4) und einer der Potentialschienen (2, 3) geschaltet ist,
    f) der Kollektor des Schutztransistors (T) in dem Halbleiterkörper (7) durch mindestens eine vergrabene Schicht (11) vom ersten Leitungstyp gebildet wird,
    mindestens eine in einem Teilbereich (10') einer epitaktischen Schicht (10) vom ersten Leitungstyp eingebrachte Basiszone (13) vom zweiten Leitungstyp, die von der vergrabenen Schicht (11) beabstandet ist, als Basis wirkt, mindestens eine in die Basiszone (13) eingebrachte Emitterzone (14) vom ersten Leitungstyp als Emitter wirkt.

**dadurch gekennzeichnet, daß**
die Basiszone (13) und die vergrabene Schicht (11) in lateraler Richtung zueinander beabstandet sind.

2. Integrierte Halbleiterschaltung nach einem der vorhergehenden Ansprüche,
**dadurch gekennzeichnet, daß** die Basis der Schutzelemente (6) über mindestens ein Ansteuermittel (D, R) angesteuert wird.

3. Integrierte Halbleiterschaltung nach Anspruch 2,
**dadurch gekennzeichnet, daß** die Ansteuermittel mindestens eine in Sperrichtung geschaltete integrierte Diode (D) enthält.

4. Integrierte Halbleiterschaltung nach einem der Ansprüche 2 oder 3,
**dadurch gekennzeichnet, daß** die Ansteuermittel mindestens einen integrierten Widerstand (R) enthält.

5. Integrierte Halbleiterschaltung nach Anspruch 4,
**dadurch gekennzeichnet, daß** der Leitwert des integrierten Widerstandes (R) von der Dotierungskonzentration in der Basiszone (13) festgelegt ist.

6. Integrierte Halbleiterschaltung nach einem der Ansprüche 1 bis 5,
**dadurch gekennzeichnet, daß** mindestens eine Anschlußzone (16) angeschlossen ist, die an die vergrabene Schicht (11) angeschlossen ist und die mit einer der Potentialschienen (2, 3) verbunden ist, wobei die Anschlußzonen (16) äquidistant durch einen zweiten Abstand (d2) von den Basiszonen (13) beabstandet sind.

7. Integrierte Halbleiterschaltung nach Anspruch 6,
**dadurch gekennzeichnet, daß** die Anschlußzone (16) als geschlossener Ring um den Teilbereich (10') angeordnet ist.

8. Integrierte Halbleiterschaltung nach einem der Ansprüche 1 bis 7,
**dadurch gekennzeichnet, daß** die Dotierungskonzentration in der vergrabenen Schicht (11) größer $1*10^{19}$ cm$^{-3}$ ist.

9. Integrierte Halbleiterschaltung nach einem der Ansprüche 1 bis 8,
**dadurch gekennzeichnet, daß** die Dotierungskonzentration in der Anschlußzone (16) größer als $1*10^{19}$ cm$^{-3}$ ist.

10. Integrierte Halbleiterschaltung nach einem der Ansprüche 1 bis 9,

**dadurch gekennzeichnet, daß** zwischen der vergrabenen Schicht (11) und dem Anschlußpad (5) eine Anodenzone vorgesehen ist.

11. Verwendung eines Schutzelements für eine integrierte Schaltung nach einem der vorhergehenden Ansprüche in einem Halbleiterspeicher oder in einem Logikbauteil oder in einem Mikrokontroller.

**Claims**

1. Integrated semiconductor circuit (1) being disposed in at least one semiconductor body (7),

    a) with at least one terminal pad (5) that is connected to said integrated semiconductor circuit (1) by an electrically conductive connection line (4),
    b) with at least one first busbar (2) carrying a first supply potential (VCC) during an operation of said integrated semiconductor circuit (1),
    c) with at least one second busbar (3) carrying a second supply potential (VSS) during an operation of said integrated semiconductor circuit (1),
    d) with at least one protective element (6) for protecting said integrated semiconductor circuit (1) against electrostatic discharge, wherein said protective element (6) is disposed between said terminal pad (5) and said integrated semiconductor circuit (1) and is connected to at least one of said first and second busbars (2, 3),
    e) wherein said protective element (6) has at least one integrated vertical protective transistor (T), whose load path is connected between said connecting line (4) and one said first and second busbars (2, 3),
    f) said collector of said protective transistor (T) is formed in said semiconductor body (7) as at least one buried layer (11) of a first conductivity type,
    at least one base zone (13) of a second conductivity type that is deposited in a partial region (10') of an epitaxial layer (10) of said first conductivity type and arranged distant from said buried layer (11) and that functions as a base,
    at least one emitter zone (14) of said first conductivity type deposited into said base zone (13) that functions as an emitter,

    **characterized in that**
    said base zone (13) and said buried layer (11) are arranged laterally distant from each other.

2. The integrated semiconductor circuit (1) according to one of the perceeding claims,
    **characterized in that**,

said base of the protective elements (6) is driven by at least one driver (D,R).

3. An integrated semiconductor circuit (1) according to claim 2,
    **characterized in that**,
    said drivers (D,R) include at least on reverse - biased integrated diode (D).

4. An integrated semiconductor circuit (1) according to one of the claims 2 or 3, **characterized in that**,
    said drivers include at least one integrated resistor (R).

5. An integrated semiconductor circuit (1) according to claim 4,
    **characterized in that**,
    a conductance of said integrated resistor (R) is defined by a doping concentration in said base zone (13).

6. An integrated semiconductor circuit (1) according to one of the claims 1 to 5,
    **characterized in that**,
    at least one connection zone (16) is connected to said buried layer (11) and to one of said first and second busbars (2, 3), wherein said connection zone (16) being spaced equidistantly from said base zones (13) by a second distance (d2).

7. An integrated semiconductor circuit (1) according to claim 6,
    **characterized in that**,
    said connection zone (16) is disposed as a closed ring around said partial region (11').

8. An integrated semiconductor circuit (1) according to one of the claims 1 to 7,
    **characterized in that**,
    said doping concentration in said buried layer (11) is greater than $1 * 10^{19}$ cm$^3$.

9. An integrated semiconductor circuit (1) according to one of the claims 1 to 8,
    **characterized in that**,
    a doping concentration in said connection zone (16) is greater than $1* 10^{19}$ cm$^{-3}$.

10. An integrated semiconductor circuit (1) according to one of the claims 1 to 9,
    **characterized in that**,
    an anode zone is provided between said buried layer (11) and said terminal pad (5).

11. Employment of a protective element for an integrated circuit according to one of the proceeding claims in a semiconductor memory or in a logic chip or in a microcontroller.

**Revendications**

1. Circuit semi-conducteur intégré (1) qui est disposé dans au moins un corps semi-conducteur (7), comportant

   a) au moins un plot de raccordement (5), qui est relié au circuit semi-conducteur intégré (1) par l'intermédiaire d'une ligne de liaison (4) électriquement conductrice,
   b) au moins un premier bus de potentiel (2), auquel est appliqué en fonctionnement un premier potentiel d'alimentation (VCC) du circuit semi-conducteur intégré (1),
   c) au moins un deuxième bus de potentiel (3), auquel est appliqué en fonctionnement un deuxième potentiel d'alimentation (VSS) du circuit semi-conducteur intégré (1),
   d) au moins un élément de protection (6), pour la protection du circuit semi-conducteur intégré (1) contre des décharges électrostatiques, l'élément de protection (6) étant disposé entre le plot de raccordement (5) et le circuit semi-conducteur intégré (1), et étant raccordé à l'un au moins des bus de potentiel (2, 3),
   e) l'élément de protection (6) comportant au moins un transistor de protection (T) intégré vertical, dont la section de charge est branchée entre la ligne de liaison (4) et l'un des bus de potentiel (2, 3),
   f) le collecteur du transistor de protection (T) dans le corps semi-conducteur (7) étant formé par au moins une couche enfouie (11) d'un premier type de conduction,
   au moins une zone de base (13) d'un deuxième type de conduction, incorporée dans une zone partielle (10') d'une couche épitaxiale (10) d'un premier type de conduction, qui est espacée de la couche enfouie (11), faisant office de base,
   au moins une zone d'émetteur (14) du premier type de conduction, incorporée dans la zone de base (13), faisant office d'émetteur,

   **caractérisé en ce que**
   la zone de base (13) et la couche enfouie (11) sont espacées l'une de l'autre dans la direction latérale.

2. Circuit semi-conducteur intégré selon l'une des revendications précédentes,
   **caractérisé en ce que** la base de l'élément de protection (6) est commandée par l'intermédiaire d'au moins un moyen de commande (D, R).

3. Circuit semi-conducteur intégré selon la revendication 2,
   **caractérisé en ce que** le moyen de commande contient au moins une diode intégrée (D) branchée dans le sens d'état bloqué.

4. Circuit semi-conducteur intégré selon l'une des revendications 2 ou 3,
   **caractérisé en ce que** le moyen de commande contient au moins une résistance intégrée (R).

5. Circuit semi-conducteur intégré selon la revendication 4,
   **caractérisé en ce que** la conductibilité spécifique de la résistance intégrée (R) est définie par la concentration de dopage dans la zone de base (13).

6. Circuit semi-conducteur intégré selon l'une des revendications 1 à 5,
   **caractérisé en ce qu'**il est raccordé au moins une zone de raccordement (16), qui est raccordée à la couche enfouie (11), et qui est reliée à l'un des bus de potentiel (2, 3), les zones de raccordement (16) étant espacées de façon équidistante de la zone de base (13) par un deuxième écartement (d2).

7. Circuit semi-conducteur intégré selon la revendication 6,
   **caractérisé en ce que** la zone de raccordement (16) est disposée autour de la zone partielle (10') sous la forme d'un anneau fermé.

8. Circuit semi-conducteur intégré selon l'une des revendications 1 à 7,
   **caractérisé en ce que** la concentration de dopage dans la couche enfouie (11) est supérieure à $1 * 10^{19}$ cm$^{-3}$.

9. Circuit semi-conducteur intégré selon l'une des revendications 1 à 8,
   **caractérisé en ce que** la concentration de dopage dans la zone de raccordement (16) est supérieure à $1 * 10^{19}$ cm$^{-3}$.

10. Circuit semi-conducteur intégré selon l'une des revendications 1 à 9,
    **caractérisé en ce qu'**une zone d'anode est prévue entre la couche enfouie (11) et le plot de raccordement (5).

11. Utilisation d'un élément de protection pour un circuit intégré selon l'une des revendications précédentes dans une mémoire semi-conductrice ou dans un composant logique ou dans un microcontrôleur.

FIG 1

FIG 2

5

$V_{SS}$

18  10'  17  14  18  10  12

$n+$
13  p  T  d2  10

16

10  n  16  15

n  n+  d  n+  9

9  n+  n+  7

11  11

p

8

FIG 3

5

$V_{SS}$

10  18 p+  17 n+  n+ 17  19'''  12

19'''  19' p+  14  19'' p+  14 p+  19'  d2  10
19'''  p  p+  16
16  p  R  p  16  10

9  p  n  n+  n  15

n+  D  13  d1  n+  D  n

11  11  7

p

8

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0768713 A2
- EP 0414934 A1
- US 4463369 A
- EP 0623958 A1

**In der Beschreibung aufgeführte Nicht-Patentliteratur**

- **J. CHEN ; X. ZHANG ; A. AMERASEKERA ; T. VROSTOS.** Design and Layout of a High ESD Performance NPN Structure for Submicron BiC-MOS/Bipolar Circuits. *Proc. Of the IEEE International Reliability Physics Symposium,* 1996, 227